# EUROPEAN PATENT SPECIFICATION

(11) **EP 4 342 902 B1**
(45) Date of publication and mention of the grant of the patent: **02.12.2026**
(21) Application number: 22884046.8
(22) Date of filing: 20.10.2022
(51) Int. Cl.: C07F 9/53, H10K 85/60

(54) **NOVEL COMPOUND AND ORGANIC LIGHT-EMITTING DEVICE INCLUDING SAME**
NEUARTIGE VERBINDUNG UND ORGANISCHE LICHTEMITTIERENDE VORRICHTUNG DAMIT
NOUVEAU COMPOSÉ ET DISPOSITIF ÉLECTROLUMINESCENT ORGANIQUE LE COMPRENANT

(30) Priority: 20.10.2021 KR 20210140466
(43) Date of publication of application: 27.03.2024
(73) Proprietor: LG Chem, Ltd., Yeongdeungpo-gu Seoul 07336 (KR)
(72) Inventor: LEE, Ho Gyu, Daejeon 34122 (KR); JUNG, Sejin, Daejeon 34122 (KR); KIM, Ji Hoon, Daejeon 34122 (KR); LEE, Jaechol, Daejeon 34122 (KR); JEONG, Su Hun, Daejeon 34122 (KR)
(74) Representative: Hoffmann Eitle
(86) International application number: PCT/KR2022/015992
(87) International publication number: WO 2023/068824

(56) References cited:
- EP-A1- 2 887 412
- KR-A- 20050 015 811
- KR-A- 20140 112 494
- KR-A- 20160 102 528
- KR-A- 20190 005 761
- KR-A- 20190 123 204
- KR-A- 20200 103 053

## Description

### [TECHNICAL FIELD]

This application claims the benefit of Korean Patent Application No. 10-2021-0140466 filed on October 20, 2021 with the Korean Intellectual Property Office.

The present disclosure relates to a novel compound and an organic light emitting device comprising the same.

### [BACKGROUND ART]

In general, an organic light emitting phenomenon refers to a phenomenon where electric energy is converted into light energy by using an organic material. The organic light emitting device using the organic light emitting phenomenon has characteristics such as a wide viewing angle, an excellent contrast, a fast response time, an excellent luminance, driving voltage and response speed, and thus many studies have proceeded.

The organic light emitting device generally has a structure which comprises an anode, a cathode, and an organic material layer interposed between the anode and the cathode. The organic material layer frequently has a multilayered structure that comprises different materials in order to enhance efficiency and stability of the organic light emitting device, and for example, the organic material layer may be formed of a hole injection layer, a hole transport layer, a light emitting layer, an electron transport layer, an electron injection layer. In the structure of the organic light emitting device, if a voltage is applied between two electrodes, the holes are injected from an anode into the organic material layer and the electrons are injected from the cathode into the organic material layer, and when the injected holes and electrons meet each other, an exciton is formed, and light is emitted when the exciton falls to a ground state again.

There is a continuous need to develop a new material for the organic material used in the organic light emitting device as described above.

Meanwhile, recently, in order to reduce process costs, an organic light emitting device using a solution process, particularly an inkjet process, has been developed instead of a conventional deposition process. In the initial stage of development, attempts have been made to develop organic light emitting devices by coating all organic light emitting device layers by a solution process, but current technology has limitations. Therefore, only HIL, HTL, and EML are processed in a layer device structure by a solution process, and a hybrid process utilizing traditional deposition processes is being studied as a subsequent process.

EP 2 887 412 A1 discloses the use of a compound comprising at least one phosphepine ring as matrix material in semiconducting.

KR 2019/0123204 A discloses an organic light emitting device comprising a positive electrode; a negative electrode; a light emitting layer between the positive electrode and negative electrode; and an electron injection layer between the positive electrode and negative electrode and light emitting layer.

Therefore, the present disclosure provides a novel material for an organic light emitting device that can be used for an organic light emitting device and at the same time, can be used for a solution process.

### [Prior Art Literature]

### [Patent Literature]

(Patent Literature 1) Korean Unexamined Patent Publication No. 10-2000-0051826

### [DETAILED DESCRIPTION OF THE INVENTION]

### [Technical Problem]

It is an object of the present disclosure to provide a novel compound and an organic light emitting device comprising the same.

### [Technical Solution]

According to an aspect of the present disclosure, there is provided a compound represented by any one of the following Chemical Formulas 1-1 to 1-4: 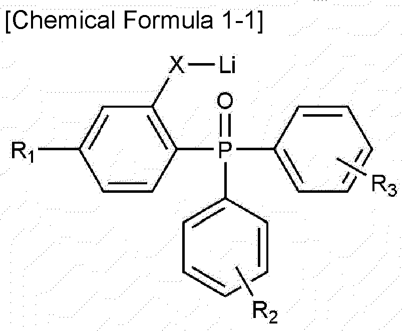 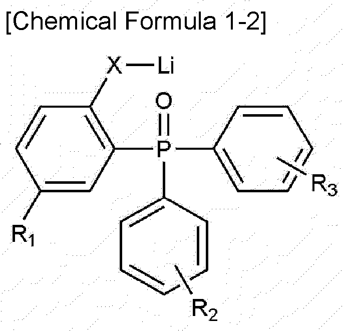 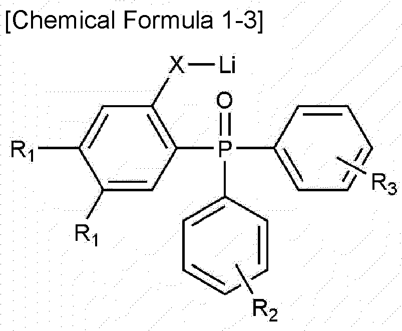 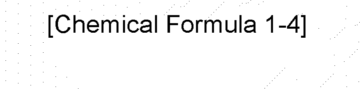 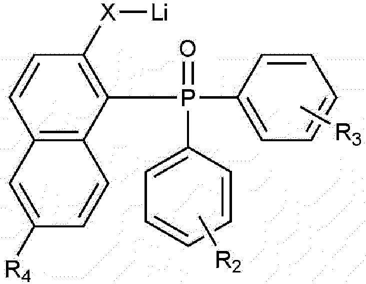
wherein, in Chemical Formulas 1-1 to 1-4,
X is O, or S,
each R₁ is independently halogen, nitro, cyano, a C₁₋₆₀ alkyl, or a C₁₋₆₀ alkyl substituted with cyano,
R₂ is hydrogen, or deuterium,
R₃ is hydrogen, deuterium, or halogen, and
R₄ is -CO-(C₁₋₆₀ alkyl).

According to another aspect of the present disclosure, there is provided an organic light emitting device comprising: a first electrode; a second electrode that is provided opposite to the first electrode; and one or more organic material layers that are provided between the first electrode and the second electrode, wherein one or more layers of the organic material layers comprises the compound represented by any one of Chemical Formulas 1-1 to 1-4.

### [ADVANTAGEOUS EFFECTS]

The above-mentioned compound represented by any one of Chemical Formulas 1-1 to 1-4 can be used as a material of an organic material layer in an organic light emitting device, can be used in a solution process, and can improve the efficiency, achieve low driving voltage and/or improve lifetime characteristics in the organic light emitting device.

### [BRIEF DESCRIPTION OF THE DRAWINGS]

Fig. 1 shows an example of an organic light emitting device comprising a substrate 1, an anode 2, a light emitting layer 3, and a cathode 4.
Fig. 2 shows an example of an organic light emitting device comprising a substrate 1, an anode 2, a hole injection layer 5, a hole transport layer 6, a light emitting layer 7, an electron transport layer 8, an electron injection layer 9, and a cathode 4.

### [DETAILED DESCRIPTION OF THE EMBODIMENTS]

Hereinafter, embodiments of the present disclosure will be described in more detail to facilitate understanding of the invention.

### (Definition of Terms)

As used herein, the notation 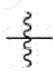 and 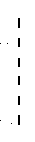 mean a bond linked to another substituent group.

As used herein, the term "substituted or unsubstituted" means being unsubstituted or substituted with one or more substituents selected from the group consisting of deuterium; a halogen group; a cyano group; a nitro group; a hydroxy group; a carbonyl group; an ester group; an imide group; an amino group; a phosphine oxide group; an alkoxy group; an aryloxy group; an alkylthioxy group; an arylthioxy group; an alkylsulfoxy group; an arylsulfoxy group; a silyl group; a boron group; an alkyl group; a cycloalkyl group; an alkenyl group; an aryl group; an aralkyl group; an aralkenyl group; an alkylaryl group; an alkylamine group; an aralkylamine group; a heteroarylamine group; an arylamine group; an arylphosphine group; and a heteroaryl containing at least one of **N,** O and S atoms, or being unsubstituted or substituted with a substituent to which two or more substituents of the above-exemplified substituents are linked. For example, "a substituent in which two or more substituents are linked" may be a biphenyl group. Namely, a biphenyl group may be an aryl group, or it may also be interpreted as a substituent in which two phenyl groups are linked.

In the present disclosure, the carbon number of a carbonyl group is not particularly limited, but is preferably 1 to 40. Specifically, it may be a compound having the following structure, but is not limited thereto.

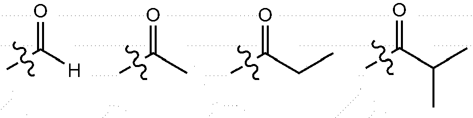

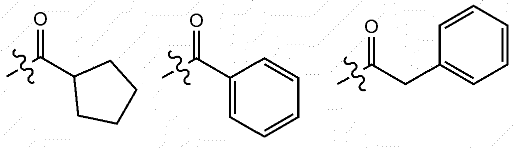

In the present disclosure, an ester group may have a structure in which oxygen of the ester group may be substituted by a straight-chain, branched-chain, or cyclic alkyl group having 1 to 25 carbon atoms, or an aryl group having 6 to 25 carbon atoms. Specifically, it may be a compound having the following structure, but is not limited thereto.

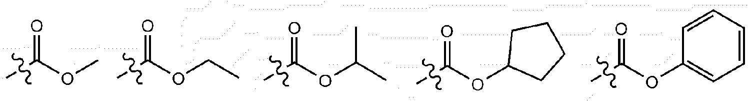

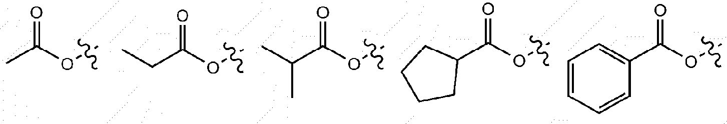

In the present disclosure, the carbon number of an imide group is not particularly limited, but is preferably 1 to 25. Specifically, it may be a compound having the following structure, but is not limited thereto.

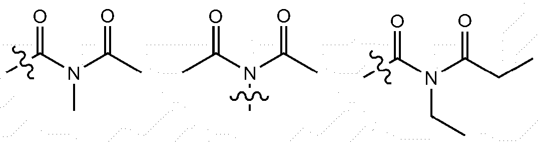

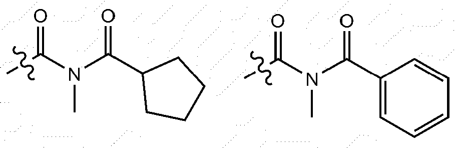

In the present disclosure, a silyl group specifically includes a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group.

**In** the present disclosure, a boron group specifically includes a trimethylboron group, a triethylboron group, a t-butyldimethylboron group, a triphenylboron group, a phenylboron group.

**In** the present disclosure, examples of a halogen group include fluorine, chlorine, bromine, or iodine.

**In** the present disclosure, the alkyl group may be straight-chain or branched-chain, and the carbon number thereof is not particularly limited, but is preferably 1 to 40. According to one embodiment, the carbon number of the alkyl group is 1 to 20. According to another embodiment, the carbon number of the alkyl group is 1 to 10. According to another embodiment, the carbon number of the alkyl group is 1 to 6. Specific examples of the alkyl group include methyl, ethyl, propyl, n-propyl, isopropyl, butyl, n-butyl, isobutyl, tert-butyl, sec-butyl, 1-methylbutyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclohectylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 2-methylpentyl, 4-methylhexyl, 5-methylhexyl.

**In** the present disclosure, the alkenyl group may be straight-chain or branched-chain, and the carbon number thereof is not particularly limited, but is preferably 2 to 40. According to one embodiment, the carbon number of the alkenyl group is 2 to 20. According to another embodiment, the carbon number of the alkenyl group is 2 to 10. According to still another embodiment, the carbon number of the alkenyl group is 2 to 6. Specific examples thereof include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group.

In the present disclosure, a cycloalkyl group is not particularly limited, but the carbon number thereof is preferably 3 to 60. According to one embodiment, the carbon number of the cycloalkyl group is 3 to 30. According to another embodiment, the carbon number of the cycloalkyl group is 3 to 20. According to still another embodiment, the carbon number of the cycloalkyl group is 3 to 6. Specific examples thereof include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl.

In the present disclosure, an aryl group is not particularly limited, but the carbon number thereof is preferably 6 to 60, and it may be a monocyclic aryl group or a polycyclic aryl group. According to one embodiment, the carbon number of the aryl group is 6 to 30. According to one embodiment, the carbon number of the aryl group is 6 to 20. The aryl group may be a phenyl group, a biphenylyl group, a terphenylyl group as the monocyclic aryl group, but is not limited thereto. The polycyclic aryl group includes a naphthyl group, an anthracenyl group, a phenanthrenyl group, a pyrenyl group, a perylenyl group, a chrysenyl group, a fluorenyl group.

In the present disclosure, the fluorenyl group may be substituted, and two substituents may be linked with each other to form a spiro structure. In the case where the fluorenyl group is substituted, 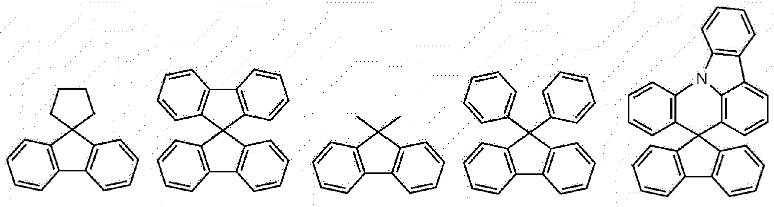 and the like can be formed.

In the present disclosure, a heteroaryl is a heteroaryl containing at least one of O, **N,** Si and S as a heteroatom, and the carbon number thereof is not particularly limited, but is preferably 2 to 60. Examples of the heteroaryl include xanthene, thioxanthene, a thiophene group, a furan group, a pyrrole group, an imidazole group, a thiazole group, an oxazol group, an oxadiazol group, a triazol group, a pyridyl group, a bipyridyl group, a pyrimidyl group, a triazine group, an acridyl group, a pyridazine group, a pyrazinyl group, a quinolinyl group, a quinazoline group, a quinoxalinyl group, a phthalazinyl group, a pyridopyrimidinyl group, a pyridopyrazinyl group, a pyrazinopyrazinyl group, an isoquinoline group, an indole group, a carbazole group, a benzoxazole group, a benzoimidazole group, a benzothiazol group, a benzocarbazole group, a benzothiophene group, a dibenzothiophene group, a benzofuranyl group, a phenanthroline group, an isoxazolyl group, a thiadiazolyl group, a phenothiazinyl group, a dibenzofuranyl group.

In the present disclosure, the aryl group in the aralkyl group, the aralkenyl group, the alkylaryl group, the arylamine group and arylsilyl group is the same as the above-mentioned examples of the aryl group. In the present disclosure, the alkyl group in the aralkyl group, the alkylaryl group and the alkylamine group is the same as the above-mentioned examples of the alkyl group. In the present disclosure, the heteroaryl in the heteroarylamine may be applied to the above-mentioned description of the heteroaryl. In the present disclosure, the alkenyl group in the aralkenyl group is the same as the above-mentioned examples of the alkenyl group. In the present disclosure, the above-mentioned description of the aryl group may be applied except that the arylene is a divalent group. In the present disclosure, the above-mentioned description of the heteroarylp can be applied except that the heteroarylene is a divalent group. In the present disclosure, the above-mentioned description of the aryl group or cycloalkyl group may be applied except that the hydrocarbon ring is not a monovalent group but formed by combining two substituent groups. In the present disclosure, the above-mentioned description of the heteroaryl may be applied except that the heterocyclic group is not a monovalent group but formed by combining two substituent groups.

### (Compound)

According to the present disclosure, there is provided the compound represented by any one of the following Chemical Formulas 1-1 to 1-4: 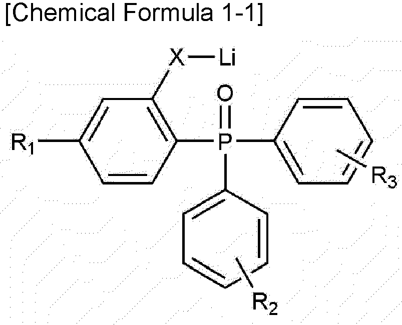 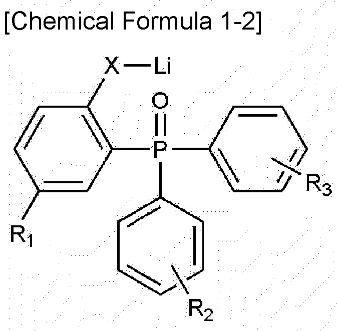 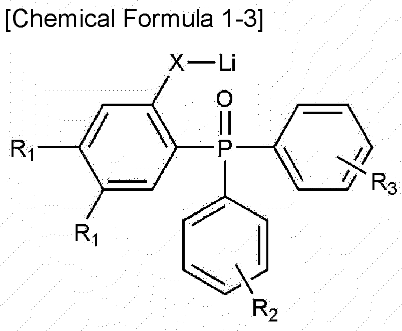 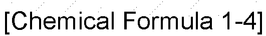 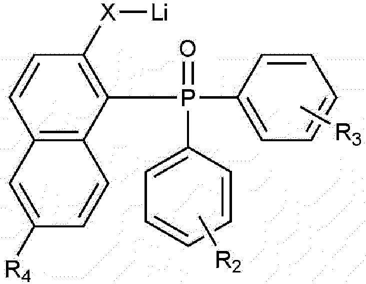
wherein, in Chemical Formulas 1-1 to 1-4,
X is O, or S,
each R₁ is independently halogen, nitro, cyano, a C₁₋₆₀ alkyl, or a C₁₋₆₀ alkyl substituted with cyano,
R₂ is hydrogen, or deuterium,
R₃ is hydrogen, deuterium, or halogen, and
R₄ is -CO-(C₁₋₆₀ alkyl).

Preferably, each R₁ is independently methyl, ethyl, propyl, isopropyl, butyl, isobutyl, tert-butyl, cyanomethyl, cyanoethyl, cyanopropyl, cyanoisopropyl, cyanobutyl, cyanoisobutyl, cyano tert-butyl, fluoro, chloro, nitro, or cyano.

Preferably, R₃ is hydrogen, or deuterium.

Preferably, R₄ is methylcarbonyl.

Representative examples of the compound represented by any one of Chemical Formulas 1-1 to 1-4 are as follows:

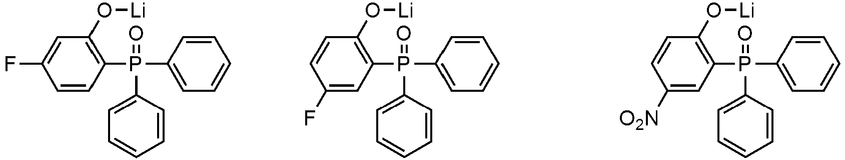

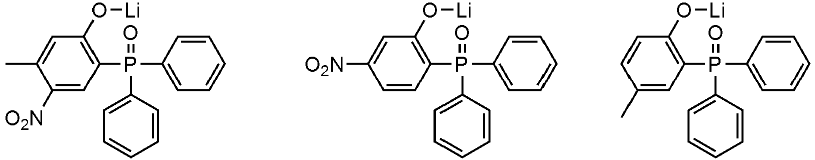

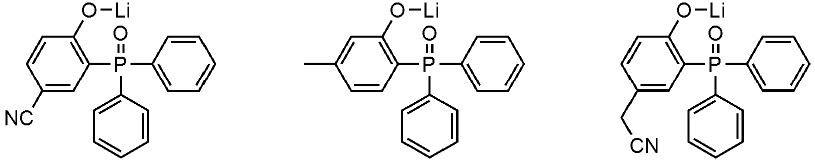

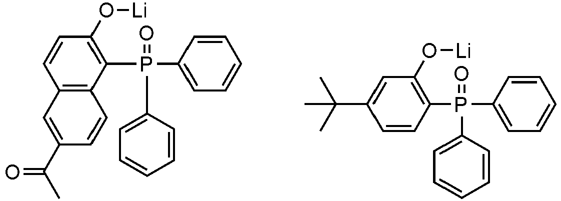

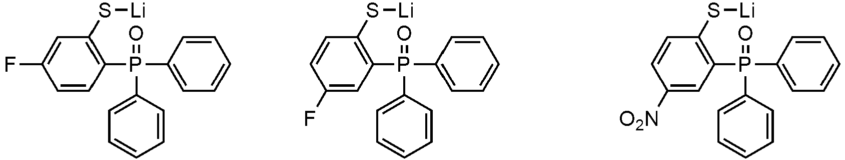

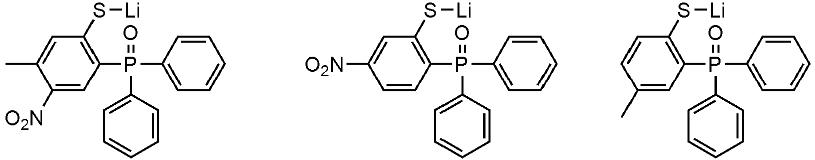

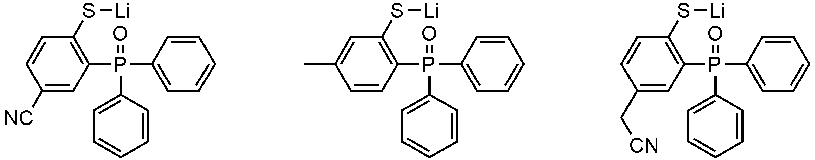

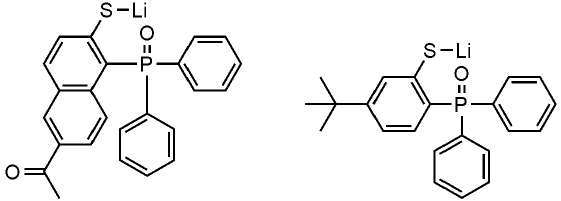

Meanwhile, according to the present disclosure, there is provided a method for preparing the compound represented by any one of Chemical Formulas 1-1 to 1-4 as shown in the following Reaction Scheme 1 as an example.

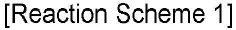

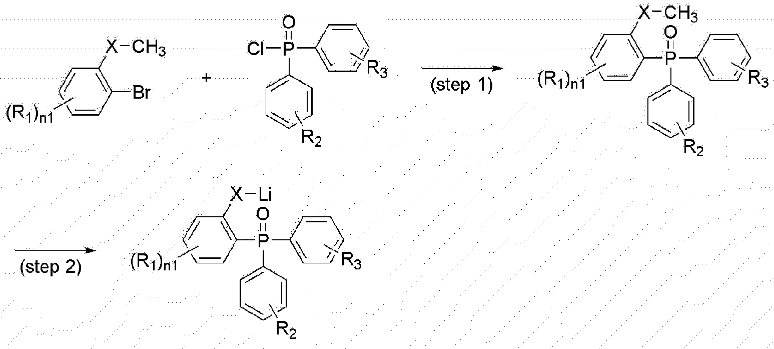

Step 1 is a Grignard reaction and uses Mg (magnesium), and the preparation method can be further embodied in Preparation Examples described hereinafter.

Step 2 is a reaction in which the product of Step 1 is reacted with an organolithium compound. The organolithium compound that can be used for the reaction can be appropriately selected according to the compound to be prepared, and lithium hydride can be used as an example. The preparation method can be further embodied in Preparation Examples described hereinafter.

Meanwhile, the organic material layer containing the compound according to the present disclosure can be formed using various methods such as a vacuum deposition method and a solution process, and the solution process will be described in detail below.

### (Coating Composition)

Meanwhile, the compound according to the present disclosure can form an organic material layer, particularly an electron transport layer or an electron injection layer, of an organic light emitting device by a solution process. For this purpose, the present disclosure provides a coating composition including the above-mentioned compound according to the present disclosure and a solvent.

**The** solvent is not particularly limited as long as it is a solvent capable of dissolving or dispersing the compound according to the present disclosure. Examples of the solvent may include chlorine-based solvents such as chloroform, methylene chloride, 1,2-dichloroethane, 1,1,2-trichloroethane, chlorobenzene and o-dichlorobenzene; ether-based solvents such as tetrahydrofuran and dioxane; aromatic hydrocarbon-based solvents such as toluene, xylene, trimethylbenzene, and mesitylene; aliphatic hydrocarbon-based solvents such as cyclohexane, methylcyclohexane, n-pentane, n-hexane, n-heptane, n-octane, n-nonane and n-decane; ketone-based solvents such as acetone, methyl ethyl ketone, and cyclohexanone; ester-based solvents such as ethyl acetate, butyl acetate and ethyl cellosolve acetate; polyalcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin and 1,2-hexanediol, and derivatives thereof; alcohol-based solvents such as methanol, ethanol, propanol, isopropanol and cyclohexanol; sulfoxide-based solvents such as dimethyl sulfoxide; amide-based solvents such as N-methyl-2-pyrrolidone and N,N-dimethylformamide; benzoate-based solvents such as butylbenzoate, and methyl-2-methoxybenzoate; tetraline; 3-phenoxy-toluene. In addition, the above-mentioned solvents may be used singly or in combination of two or more solvents. Preferably, toluene may be used as the solvent.

Further, the viscosity of the coating composition is preferably 0.001 Pa·s (1 cP) or more. Also, in consideration of the easiness of coating the coating composition, the viscosity of the coating composition is preferably 0.01 Pa·s (10 cP) or less. Moreover, the concentration of the compound according to the present disclosure in the coating composition is preferably 0.1 wt/v% or more. **In** addition, the concentration of the compound according to the present disclosure in the coating composition is preferably 20 wt/v% or less so that the coating composition can be optimally coated.

In another embodiment of the present disclosure, there is provided a method for forming a light emitting layer using the above-mentioned coating composition. Specifically, the method includes the steps of: coating the above-mentioned light emitting layer according to the present disclosure onto the anode or on the hole transport layer formed on the anode by a solution process; and heat-treating the coated coating composition.

The solution process uses the above-mentioned coating composition according to the present disclosure, and refers to, e.g., spin coating, dip coating, doctor blading, inkjet printing, screen printing, spray method, roll coating.

The heat treatment temperature in the heat treatment step is preferably from 150 to 230°C. Further, a heat treatment time may be 1 minute to 3 hours, more preferably 10 minutes to 1 hour. Further, the heat treatment is preferably carried out in an inert gas atmosphere such as argon and nitrogen.

### (Organic light emitting device)

Further, according to the present disclosure, there is provided an organic light emitting device comprising a compound represented by any one of Chemical Formulas 1-1 to 1-4. In one embodiment of the present disclosure, there is provided an organic light emitting device comprising: a first electrode; a second electrode that is provided opposite to the first electrode; and one or more organic material layers that are provided between the first electrode and the second electrode, wherein one or more layers of the organic material layers includes the compound represented by any one of Chemical Formulas 1-1 to 1-4.

The organic material layer of the organic light emitting device of the present disclosure may have a single-layer structure, or it may have a multilayered structure in which two or more organic material layers are stacked. For example, the organic light emitting device of the present disclosure may have a structure comprising, e.g., a hole injection layer, a hole transport layer, a light emitting layer, an electron transport layer, an electron injection layer. However, the structure of the organic light emitting device is not limited thereto, and it may include a smaller number of organic layers.

Further, the organic material layer may include an electron transport layer or an electron injection layer, wherein the electron transport layer or the electron injection layer includes the compound represented by any one of Chemical Formulas 1-1 to 1-4.

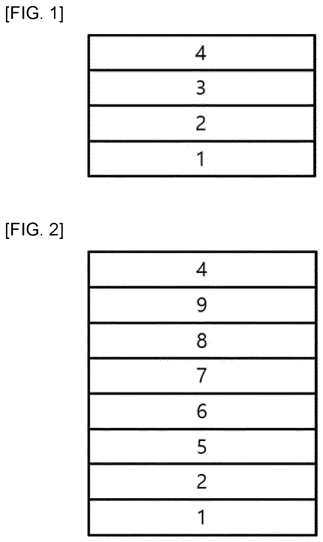

Further, the organic light emitting device according to the present disclosure may be a normal type organic light emitting device in which an anode, one or more organic material layers, and a cathode are sequentially stacked on a substrate. Further, the organic light emitting device according to the present disclosure may be an inverted type organic light emitting device in which a cathode, one or more organic material layers, and an anode are sequentially stacked on a substrate. For example, the structure of the organic light emitting device according to an embodiment of the present disclosure is illustrated in Figs. 1 and 2.

Fig. 1 shows an example of an organic light emitting device comprising a substrate 1, an anode 2, a light emitting layer 3, and a cathode 4. **In** such a structure, the compound represented by any one of Chemical Formulas 1-1 to 1-4 may be included in the light emitting layer.

Fig. 2 shows an example of an organic light emitting device comprising a substrate 1, an anode 2, a hole injection layer 5, a hole transport layer 6, a light emitting layer 7, an electron transport layer 8, an electron injection layer 9, and a cathode 4. **In** such a structure, the compound represented by any one of Chemical Formulas 1-1 to 1-4 may be included in the electron transport layer or the electron injection layer.

**The** organic light emitting device according to the present disclosure may be manufactured by materials and methods known in the art, except that at least one of the organic material layers includes the compound represented by any one of Chemical Formulas 1-1 to 1-4. Further, when the organic light emitting device includes a plurality of organic material layers, the organic material layers can be formed of the same material or different materials.

For example, the organic light emitting device according to the present disclosure can be manufactured by sequentially stacking an anode, an organic material layer and a cathode on a substrate. In this case, the organic light emitting device may be manufactured by depositing a metal, metal oxides having conductivity, or an alloy thereof on the substrate using a PVD (physical vapor deposition) method such as a sputtering method or an e-beam evaporation method to form an anode, forming organic material layers including the hole injection layer, the hole transport layer, the light emitting layer and the electron transport layer thereon, and then depositing a material that can be used as the cathode thereon.

In addition to such a method, the organic light emitting device may be manufactured by sequentially depositing a cathode material, an organic material layer and an anode material on a substrate (International Publication WO2003/012890). However, the manufacturing method is not limited thereto.

As an example, the first electrode is an anode, and the second electrode is a cathode, or alternatively, the first electrode is a cathode and the second electrode is an anode.

As the anode material, generally, a material having a large work function is preferably used so that holes can be smoothly injected into the organic material layer. Specific examples of the anode material include metals such as vanadium, chrome, copper, zinc, and gold, or an alloy thereof; metal oxides such as zinc oxides, indium oxides, indium tin oxides (ITO), and indium zinc oxides (IZO); a combination of metals and oxides, such as ZnO:Al or SnO₂:Sb; conductive compounds such as poly(3-methylthiophene), poly[3,4-(ethylene-1,2-dioxy)thiophene](PEDOT), polypyrrole, and polyaniline.

As the cathode material, generally, a material having a small work function is preferably used so that electrons can be easily injected into the organic material layer. Specific examples of the cathode material include metals such as magnesium, calcium, sodium, potassium, titanium, indium, yttrium, lithium, gadolinium, aluminum, silver, tin, and lead, or an alloy thereof; a multilayered structure material such as LiF/Al or LiO₂/Al.

**The** organic light emitting device according to the present disclosure may include a hole transport layer between the electron blocking layer and the anode.

**The** hole transport layer is a layer that receives holes from a hole injection layer and transports the holes to the light emitting layer. **The** hole transport material is suitably a material having large mobility to the holes, which may receive holes from the anode or the hole injection layer and transfer the holes to the light emitting layer.

Specific examples of the hole transport material include an arylamine-based organic material, a conductive polymer, a block copolymer in which a conjugate portion and a non-conjugate portion are present together.

**The** organic light emitting device according to the present disclosure may further include a hole injection layer between the anode and the hole transport layer, if necessary.

**The** hole injection layer is a layer for injecting holes from the electrode, and the hole injection material is preferably a compound which has a capability of transporting the holes, thus has a hole injecting effect in the anode and an excellent hole injecting effect to the light emitting layer or the light emitting material, prevents excitons produced in the light emitting layer from moving to a hole injection layer or the electron injection material, and further is excellent in the ability to form a thin film. It is preferable that a HOMO (highest occupied molecular orbital) of the hole injection material is between the work function of the anode material and a HOMO of a peripheral organic material layer.

Specific examples of the hole injection material include metal porphyrine, oligothiophene, an arylamine-based organic material, a hexanitrilehexaazatriphenylene-based organic material, a quinacridone-based organic material, a perylene-based organic material, anthraquinone, polyaniline and polythiophene-based conductive polymer.

The organic light emitting device according to the present disclosure may include an electron transport layer between the light emitting layer and the cathode.

The electron transport layer is a layer that receives electrons from a cathode or an electron injection layer formed on the cathode and transports the electrons to the light emitting layer, and that suppress the transfer of holes from the light emitting layer, and an electron transport material is suitably a material which may receive electrons well from a cathode and transfer the electrons to a light emitting layer, and has a large mobility for electrons.

Specific examples of the electron transport material include: an Al complex of 8-hydroxyquinoline; a complex including Alq₃; an organic radical compound; a hydroxyflavone-metal complex. The electron transport layer may be used with any desired cathode material, as used according to a conventional technique. In particular, appropriate examples of the cathode material are a typical material which has a low work function, followed by an aluminum layer or a silver layer. Specific examples thereof include cesium, barium, calcium, ytterbium, and samarium, in each case followed by an aluminum layer or a silver layer.

**The** organic light emitting device according to the present disclosure may further include an electron injection layer between the electron transport layer and the cathode, if necessary.

**The** electron injection layer is a layer which injects electrons from an electrode, and is preferably a compound which has a capability of transporting electrons, has an effect of injecting electrons from a cathode and an excellent effect of injecting electrons into a light emitting layer or a light emitting material, prevents excitons produced from the light emitting layer from moving to a hole injection layer, and is also excellent in the ability to form a thin film.

Specific examples of materials that can be used as the electron injection layer include fluorenone, anthraquinodimethane, diphenoquinone, thiopyran dioxide, oxazole, oxadiazole, triazole, imidazole, perylenetetracarboxylic acid, fluorenylidene methane, anthrone, and derivatives thereof, a metal complex compound, a nitrogen-containing 5-membered ring derivative.

**The** metal complex compound includes 8-hydroxyquinolinato lithium, bis(8-hydroxyquinolinato)zinc, bis(8-hydroxyquinolinato)copper, bis(8-hydroxyquinolinato)manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)beryllium, bis(10-hydroxybenzo[h]quinolinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum, bis(2-methyl-8-quinolinato)(2-naphtholato)gallium.

**In** addition to the above-mentioned materials, the light emitting layer, the hole injection layer, the hole transport layer, the electron transport layer, and the electron injection layer may further include an inorganic compound or a polymer compound such as quantum dots.

The quantum dots may be, for example, colloidal quantum dots, alloy quantum dots, core-shell quantum dots, or core quantum dots. It may be a quantum dot including elements belonging to groups 2 and 16, elements belonging to groups 13 and 15, elements belonging to groups 13 and 17, elements belonging to groups 11 and 17, or elements belonging to groups 14 and 15. Quantum dots including elements such as cadmium (Cd), selenium (Se), zinc (Zn), sulfur (S), phosphorus (P), indium (In), tellurium (Te), lead (Pb), gallium (Ga), arsenic (As) can be used.

The organic light emitting device according to the present disclosure may be a bottom emission device, a top emission device, or a double-sided light emitting device, and in particular, may be a bottom emission device that requires relatively high luminous efficiency.

In addition, the compound according to the present disclosure may be included in an organic solar cell or an organic transistor in addition to an organic light emitting device.

Hereinafter, the preparation of the compound represented by any one of Chemical Formulas 1-1 to 1-4 and the organic light emitting device including the same will be specifically described in the following Examples. However, the following Examples are provided for illustrative purposes only, and are not intended to limit the scope of the present disclosure.

### [EXAMPLE]

### Example 1: Preparation of Compound 1

### (Step 1)

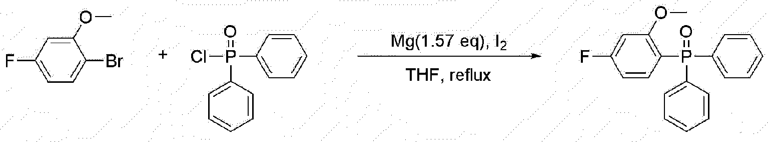

Magnesium (1,241 mg, 51.0520 mmol), and anhydrous tetrahydrofuran (25 mL) were added to a flask, and then stirred at room temperature. 1-Bromo-4-fluoro-2-methoxybenzene (7 g, 34.1430 mmol, 4.38 mL) was added to the flask, to which a trace amount of iodine was added. The flask was heated to 80°C and the mixture was stirred for 1 hour. The flask was cooled back to room temperature, and diphenylphosphinyl chloride (7.964 g, 32.5172 mmol, 6.42 mL) was dissolved in anhydrous tetrahydrofuran (25 mL) and slowly added. The resulting mixture was stirred at room temperature for 15 hours. The reaction mixture was heated to reflux and stirred for 3 hours. The flask was again allowed to cool to room temperature, and methanol (20 mL) was added to terminate the reaction. The solvent was blown away with an evaporator, excess chloroform was used, and filtered to remove the solid and obtain a lower layer chloroform solution. The solvent was removed by an evaporator and dried to obtain (4-fluoro-2-methoxyphenyl)diphenylphosphine oxide (7.8 g).

### (Step 2)

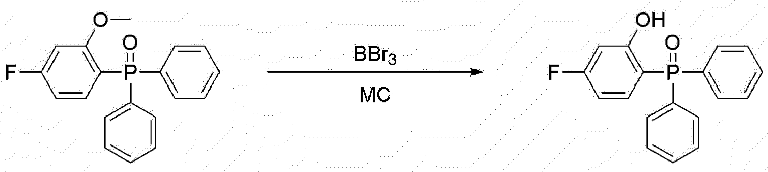

(4-Fluoro-2-methoxyphenyl)diphenylphosphine oxide (7.8 g, 25.2984 mmol) prepared in step 1, and dichloromethane (20 mL) were added to a flask and then stirred at -5°C for 30 minutes. Tribromo borane (6.972 g, 27.8282 mmol, 2.68 mL) was slowly added to the flask while maintaining the flask at -5°C, and the mixture was stirred for 15 hours while raising the temperature to room temperature. **The** reaction was terminated using methanol (15 mL), and the reaction solution was neutralized using a saturated aqueous sodium hydrogen carbonate solution. **The** reaction solution was extracted using chloroform. **The** solvent of the extracted organic layer was removed and precipitated with hexane using a minimum amount of chloroform to obtain (4-fluoro-2-hydroxyphenyl) diphenylphosphine oxide (5.5 g).

### (Step 3)

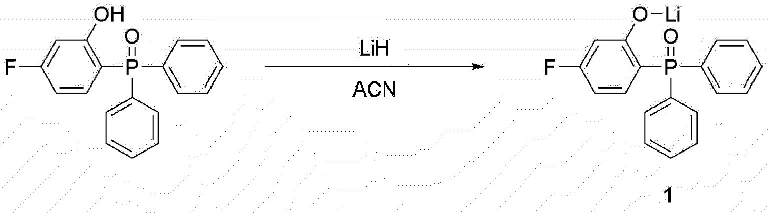

(4-Fluoro-2-hydroxyphenyl)diphenylphosphine oxide (5.5 g, 17.6124 mmol) prepared in step 2, and anhydrous acetonitrile (103 mL) were added to a flask, and then stirred for 5 minutes. Lithium hydride (140 mg, 17.6124 mmol) was added to the flask and then stirred for 24 hours. After completion of the reaction, the reaction solution was filtered using acetonitrile to obtain a solid. The obtained solid was sublimed to obtain Compound 1 (3 g).
m/z: 312.07

### Example 2: Preparation of Compound 2

### (Step 1)

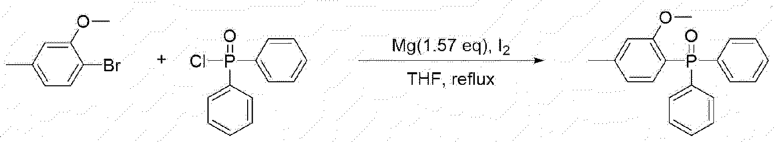

Magnesium (1.266 g, 52.0574 mmol), and anhydrous tetrahydrofuran (25 mL) were added to a flask, and then stirred at room temperature. 1-Bromo-2-methoxy-4-methylbenzene (7 g, 34.8155 mmol, 5.03 mL) was added to the flask, to which a trace amount of iodine was added. The flask was heated to 80°C and the mixture was stirred for 1 hour. The flask was cooled back to room temperature, and diphenylphosphinyl chloride (7.846 g, 33.1576 mmol, 6.33 mL) was dissolved in anhydrous tetrahydrofuran (25 mL) and slowly added. The resulting mixture was stirred at room temperature for 15 hours. The reaction mixture was heated to reflux and stirred for 3 hours. The flask was again allowed to cool to room temperature, and methanol (20 mL) was added to terminate the reaction. The solvent was blown away with an evaporator, excess chloroform was used, and filtered to remove the solid and obtain a lower layer chloroform solution. The solvent was removed by an evaporator and dried to obtain (2-methoxy-4-methylphenyl) diphenylphosphine oxide (10.6 g).

### (Step 2)

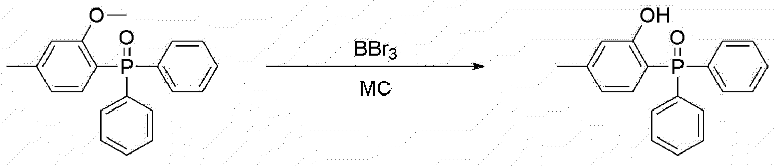

(2-Methoxy-4-methylphenyl)diphenylphosphine oxide (10.6 g, 32.8845 mmol) prepared in step 1, and dichloromethane (25 mL) were added to a flask and then stirred at -5°C for 30 minutes. Tribromo borane (9.062 g, 36.1730 mmol, 3.49 mL) was slowly added to the flask while maintaining the flask at -5°C, and the mixture was stirred for 15 hours while raising the temperature to room temperature. The reaction was terminated using methanol (15 mL), and the reaction solution was neutralized using a saturated aqueous sodium hydrogen carbonate solution. The reaction solution was extracted using chloroform. The solvent of the extracted organic layer was removed and precipitated with hexane using a minimum amount of chloroform to obtain (2-hydroxy-4-methylphenyl) diphenylphosphine oxide (6.5 g).

### (Step 3)

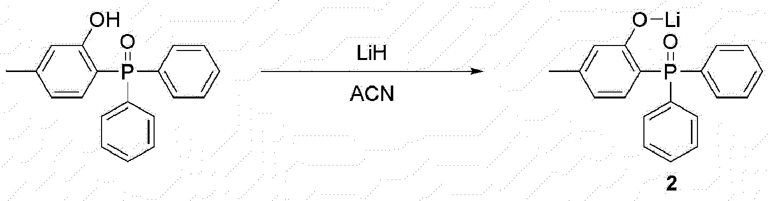

(2-Hydroxy-4-methylphenyl)diphenylphosphine oxide (6.5 g, 21.0820 mmol) prepared in step 2, and anhydrous acetonitrile (125 mL) were added to a flask, and then stirred for 5 minutes. Lithium hydride (168 mg, 21.0820 mmol) was added to the flask and then stirred for 24 hours. After completion of the reaction, the reaction solution was filtered using acetonitrile to obtain a solid. The obtained solid was sublimed to obtain Compound 2 (4.3 g).
m/z: 308.10

### Example 3: Preparation of Compound 3

### (Step 1)

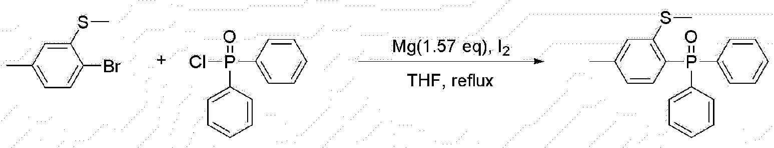

Magnesium (1.266 g, 52.0574 mmol), and anhydrous tetrahydrofuran (25 mL) were added to a flask, and then stirred at room temperature. (2-Bromo-5-methylphenyl)(methyl)sulfane (7 g, 32.2402 mmol) was added to the flask, to which a trace amount of iodine was added. The flask was heated to 80°C and the mixture was stirred for 1 hour. The flask was cooled back to room temperature, and diphenylphosphinyl chloride (7.629 g, 32.2402 mmol, 6.15 mL) was dissolved in anhydrous tetrahydrofuran (25 mL) and slowly added. The resulting mixture was stirred at room temperature for 15 hours. The reaction mixture was heated to reflux and stirred for 3 hours. The flask was again allowed to cool to room temperature, and methanol (20 mL) was added to terminate the reaction. The solvent was blown away with an evaporator, excess chloroform was used, and filtered to remove the solid and obtain a lower layer chloroform solution. The solvent was removed by an evaporator and dried to obtain (4-methyl-2-(methylthio)phenyl)diphenylphosphine oxide (10.9 g).

### (Step 2)

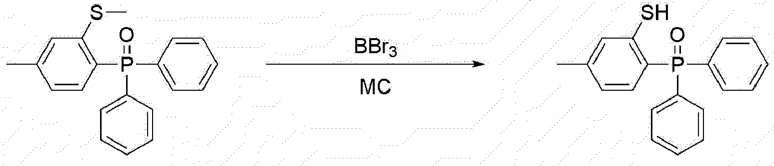

(4-Methyl-2-(methylthio)phenyl)diphenylphosphine oxide (10.9 g, 32.2104 mmol) prepared in step 1, and dichloromethane (25 mL) were added to a flask and then stirred at -5°C for 30 minutes. Tribromo borane (8.876 g, 35.4314 mmol, 3.41 mL) was slowly added to the flask while maintaining the flask at -5°C, and the mixture was stirred for 15 hours while raising the temperature to room temperature. The reaction was terminated using methanol (15 mL), and the reaction solution was neutralized using a saturated aqueous sodium hydrogen carbonate solution. The reaction solution was extracted using chloroform. The solvent of the extracted organic layer was removed and precipitated with hexane using a minimum amount of chloroform to obtain (2-mercapto-4-methylphenyl) diphenylphosphine oxide (6.1 g).

### (Step 3)

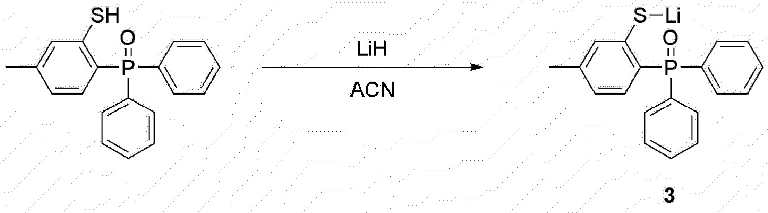

(2-Mercapto-4-methylphenyl)diphenylphosphine oxide (6.1 g, 18.8051 mmol) prepared in step 2, and anhydrous acetonitrile (110 mL) were added to a flask, and then stirred for 5 minutes. Lithium hydride (150 mg, 18.8051 mmol) was added to the flask and then stirred for 24 hours. After completion of the reaction, the reaction solution was filtered using acetonitrile to obtain a solid. The obtained solid was sublimed to obtain Compound 3 (3.8 g).
m/z: 324.07

### Example 4: Preparation of Compound 4

### (Step 1)

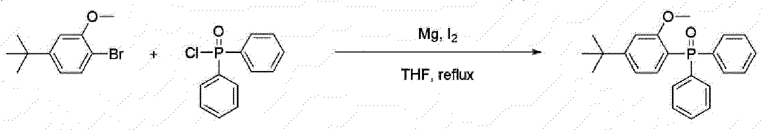

Magnesium (1.091 g, 44.8571 mmol), and anhydrous tetrahydrofuran (25 mL) were added to a flask, and then stirred at room temperature. 1-Bromo-4-(tert-butyl)-2-methoxybenzene (7.294 g, 30.00 mmol) was added to the flask, to which a trace amount of iodine was added. The flask was heated to 80°C and the mixture was stirred for 1 hour. The flask was cooled back to room temperature, and diphenylphosphinyl chloride (6.761 g, 28.5714 mmol, 5.45 mL) was dissolved in anhydrous tetrahydrofuran (25 mL) and slowly added. The resulting mixture was stirred at room temperature for 15 hours. The reaction mixture was heated to reflux and stirred for 3 hours. The flask was again allowed to cool to room temperature, and methanol (20 mL) was added to terminate the reaction. The solvent was blown away with an evaporator, excess chloroform was used, and filtered to remove the solid and obtain a lower layer chloroform solution. The solvent was removed by an evaporator and dried to obtain (4-(tert-butyl)-2-methoxyphenyl)diphenylphosphine oxide (10.4 g).

### (Step 2)

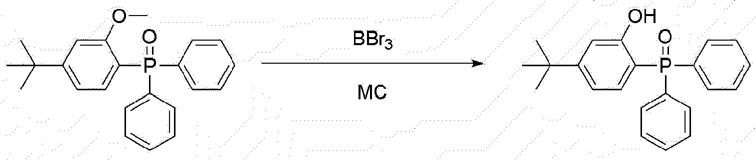

(4-(Tert-butyl)-2-methoxyphenyl)diphenylphosphine oxide (10.4 g, 28.5385 mmol) prepared in step 1, and dichloromethane (25 mL) were added to a flask and then stirred at -5°C for 30 minutes. Tribromo borane (7.864 g, 31.3923 mmol, 3.02 mL) was slowly added to the flask while maintaining the flask at -5°C, and the mixture was stirred for 15 hours while raising the temperature to room temperature. The reaction was terminated using methanol (15 mL), and the reaction solution was neutralized using a saturated aqueous sodium hydrogen carbonate solution. The reaction solution was extracted using chloroform. The solvent of the extracted organic layer was removed and precipitated with hexane using a minimum amount of chloroform to obtain (4-(tert-butyl)-2-hydroxyphenyl)diphenylphosphine oxide (8.4 g).

### (Step 3)

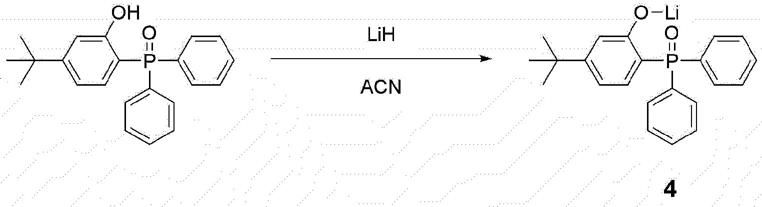

(4-(Tert-butyl)-2-hydroxyphenyl)diphenylphosphine oxide (8.4 g, 23.9726 mmol) prepared in step 2, and anhydrous acetonitrile (100 mL) were added to a flask, and then stirred for 5 minutes. Lithium hydride (191 mg, 23.9726 mmol) was added to the flask and then stirred for 24 hours. After completion of the reaction, the reaction solution was filtered using acetonitrile to obtain a solid. The obtained solid was sublimed to obtain Compound 4 (5.5 g).
m/z: 356.15

### Example 5: Preparation of Compound 5

### (Step 1)

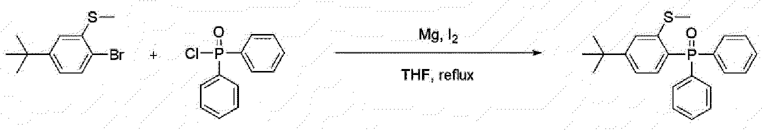

Magnesium (1.272 g, 52.3333 mmol), and anhydrous tetrahydrofuran (25 mL) were added to a flask, and then stirred at room temperature. (2-Bromo-5-(tert-butyl)phenyl)(methyl)sulfane (9.072 g, 35 mmol) was added to the flask, to which a trace amount of iodine was added. The flask was heated to 80°C and the mixture was stirred for 1 hour. The flask was cooled back to room temperature, and diphenylphosphinyl chloride (8.788 g, 33.3333 mmol, 7.09 mL) was dissolved in anhydrous tetrahydrofuran (25 mL) and slowly added. The resulting mixture was stirred at room temperature for 15 hours. The reaction mixture was heated to reflux and stirred for 3 hours. The flask was again allowed to cool to room temperature, and methanol (20 mL) was added to terminate the reaction. The solvent was blown away with an evaporator, excess chloroform was used, and filtered to remove the solid and obtain a lower layer chloroform solution. The solvent was removed by an evaporator and dried to obtain (4-(tert-butyl)-2-(methylthio)phenyl)diphenylphosphine oxide (12.7 g).

### (Step 2)

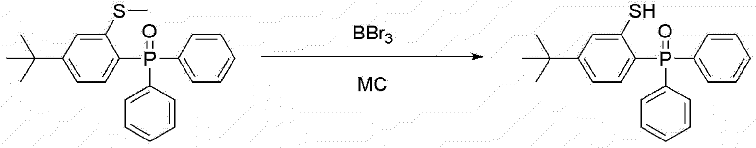

(4-(Tert-butyl)-2-(methylthio)phenyl)diphenylphosphine oxide (12.7 g, 33.3780 mmol) prepared in step 1, and dichloromethane (25 mL) were added to a flask and then stirred at -5°C for 30 minutes. Tribromo borane (9.198 g, 36.7158 mmol, 3.54 mL) was slowly added to the flask while maintaining the flask at -5°C, and the mixture was stirred for 15 hours while raising the temperature to room temperature. The reaction was terminated using methanol (15 mL), and the reaction solution was neutralized using a saturated aqueous sodium hydrogen carbonate solution. The reaction solution was extracted using chloroform. The solvent of the extracted organic layer was removed and precipitated with hexane using a minimum amount of chloroform to obtain (4-(tert-butyl)-2-mercaptophenyl)diphenylphosphine oxide (9.6 g).

### (Step 3)

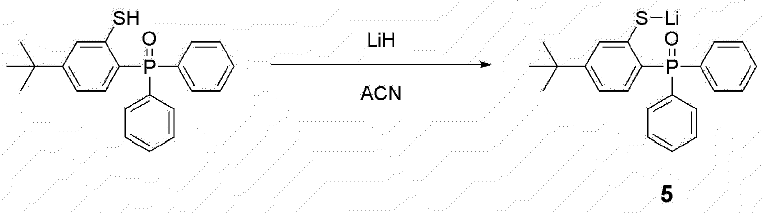

(4-(Tert-butyl)-2-mercaptophenyl)diphenylphosphine oxide (9.6 g, 26.1965 mmol) prepared in step 2, and anhydrous acetonitrile (100 mL) were added to a flask, and then stirred for 5 minutes. Lithium hydride (208 mg, 26.1965 mmol) was added to the flask and then stirred for 24 hours. After completion of the reaction, the reaction solution was filtered using acetonitrile to obtain a solid. The obtained solid was sublimed to obtain Compound 5 (6.2 g).
m/z: 372.13

### [EXPERIMENTAL EXAMPLE]

### Experimental Example 1

A glass substrate on which a thin film of ITO (indium tin oxide) was coated in a thickness of 500 Å was put into distilled water containing the detergent dissolved therein and washed by the ultrasonic wave. In this case, the used detergent was a product commercially available from Fisher Co. and the distilled water was one which had been twice filtered by using a filter commercially available from Millipore Co. The ITO was washed for 30 minutes, and ultrasonic washing was then repeated twice for 10 minutes by using distilled water. After the cleaning with distilled water was completed, the substrate was ultrasonically washed with solvents of isopropyl alcohol and acetone, dried, and then the substrate was cleaned for 5 minutes and then transferred to a glove box.

A coating composition, in which the following Compound p-dopant and the following Compound HIL (weight ratio of 2:8) were dissolved in cyclohexanone at 5 wt/v%, was spin-coated (2500 rpm) on the ITO transparent electrode, and heat-treated (cured) at 230°C for 30 minutes to form a hole injection layer with a thickness of 1000 Å. A coating composition, in which the following polymer HTL (Mn: 27,900; Mw: 35,600; measured by GPC (Agilent 1200 series) using PC Standard) was dissolved in toluene at 2 wt/v%, was spin-coated (2500 rpm) on the hole injection layer, and heat-treated at 230°C for 30 minutes to form a hole transport layer with a thickness of 1000 Å. A coating composition, in which the following Compound A and the following Compound Dopant (weight ratio of 98:2) were dissolved in cyclohexanone at 2 wt/v%, was spin-coated (2000 rpm) on the hole transport layer, and heat-treated at 145°C for 15 minutes to form a light emitting layer with a thickness of 400 Å.

A coating composition, in which the following Compound ETL and the Compound prepared in the previous Example 1 (weight ratio of 3:7) were dissolved in ethylene glycol and 1-propanol (volume ratio of 8:2) at 2 wt%, was spin-coated (2000 rpm) on the light emitting layer, and heat-treated at 145°C for 10 minutes to form an electron injection and transport layer with a thickness of 300 Å. Aluminum was deposited to a thickness of 1000 Å on the electron injection and transport layer, to form a cathode, thereby manufacturing the organic light emitting device.

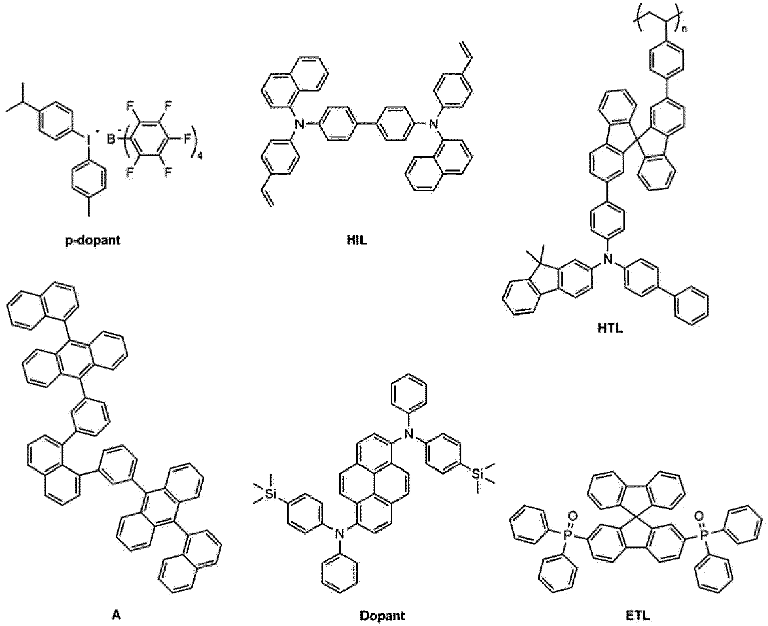

In the above-mentioned processes, the deposition rate of aluminum of the cathode were maintained at 2 Å/sec, and the degree of vacuum during the deposition was maintained at 2x10⁻⁷ ~ 5x10⁻⁸ Torr (266.644x10⁻⁷ ~ 1166.61x10⁻⁸ Pa).

### Experimental Examples 2 to 5

The organic light emitting devices were manufactured in the same manner as in Experimental Example 1, except that the compounds shown in Table 1 below was used instead of Compound 1.

### Comparative Experimental Examples 1 to 3

The organic light emitting devices were manufactured in the same manner as in Experimental Example 1, except that the following Compound C1 (LiQ; 8-Quinolinolato Lithium), Compound C2, and Compound C3 were used instead of Compound 1.

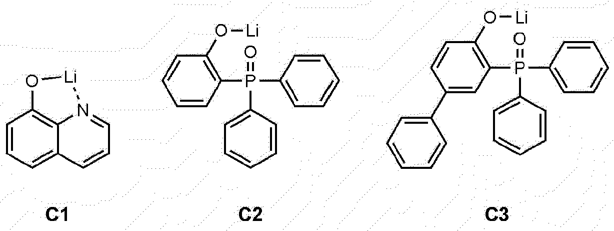

The driving voltage, current efficiency and lifetime were measured at a current density of 10 mA/cm² by applying a current to the organic light emitting devices manufactured in the Experimental Examples and Comparative Experimental Examples, and the results are shown in Table 1 below. At this time, the lifetime (T90) means the time required for the luminance to be reduced to 90% of the initial luminance (500 cd/m² (500 nit)).

**[Table 1]**

| | Compound | Driving voltage (V@10mA/cm²) | Current efficiency (cd/A@10mA/cm²) | Lifetime (hr) (T90@500 cd/m² (500 nit)) |
|---|---|---|---|---|
| Experimental Example 1 | Compound 1 | 5.78 | 5.89 | 47 |
| Experimental Example 2 | Compound 2 | 5.64 | 5.93 | 65 |
| Experimental Example 3 | Compound 3 | 6.09 | 5.26 | 42 |
| Experimental Example 4 | Compound 4 | 5.84 | 5.69 | 43 |
| Experimental Example 5 | Compound 5 | 5.71 | 5.85 | 54 |
| Comparative Experimental Example 1 | Compound C1 | 6.41 | 4.78 | 25 |
| Comparative Experimental Example 2 | Compound C2 | 6.04 | 5.47 | 40 |
| Comparative Experimental Example 3 | Compound C3 | 6.34 | 5.35 | 27 |

As shown in Table 1, it was confirmed that when the compound according to the present disclosure was used, the driving voltage was reduced, the current efficiency was increased and the lifetime was improved as compared to the case of using Comparative Example Compounds including LiQ commonly used in the art.

### [Description of Symbols]

| | | | |
|---|---|---|---|
| 1: | substrate | 2: | anode |
| 3: | light emitting layer | 4: | cathode |
| 5: | hole injection layer | 6: | hole transport layer |
| 7: | light emitting layer | 8: | electron transport layer |
| 9: | electron injection layer | | |

## Claims

1. A compound represented by any one of the following Chemical Formulas 1-1 to 1-4: 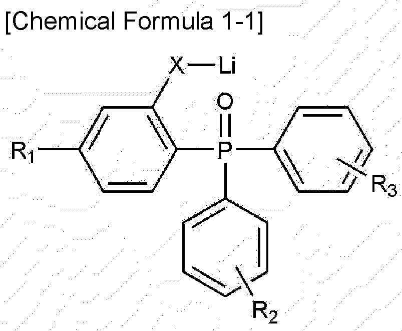 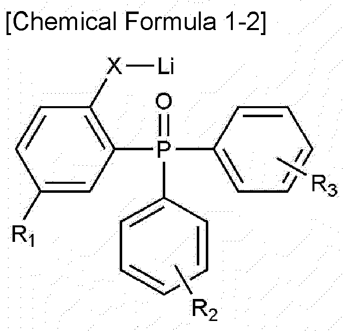 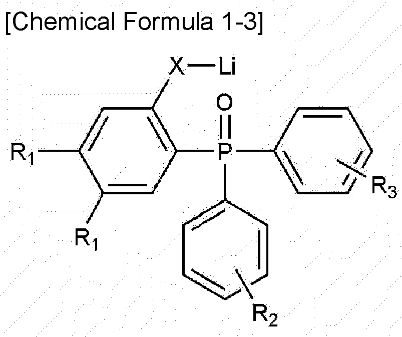 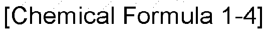 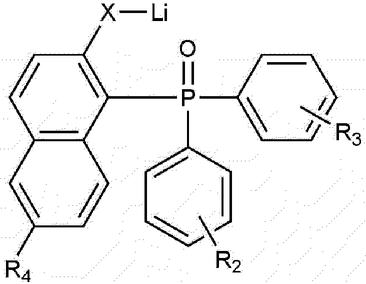
wherein, in Chemical Formulas 1-1 to 1-4,
X is O, or S,
each R₁ is independently halogen, nitro, cyano, a C₁₋₆₀ alkyl, or a C₁₋₆₀ alkyl substituted with cyano,
R₂ is hydrogen, or deuterium,
R₃ is hydrogen, deuterium, or halogen, and
R₄ is -CO-(C₁₋₆₀ alkyl).

2. The compound according to claim 1, wherein:
each R₁ is independently methyl, ethyl, propyl, isopropyl, butyl, isobutyl, tert-butyl, cyanomethyl, cyanoethyl, cyanopropyl, cyanoisopropyl, cyanobutyl, cyanoisobutyl, cyano tert-butyl, fluoro, chloro, nitro, or cyano.

3. The compound according to claim 1, wherein:
R₃ is hydrogen, or deuterium.

4. The compound according to claim 1, wherein:
the compound represented by any one of the following Chemical Formulas 1-1 to 1-4 is any one selected from the group consisting of:

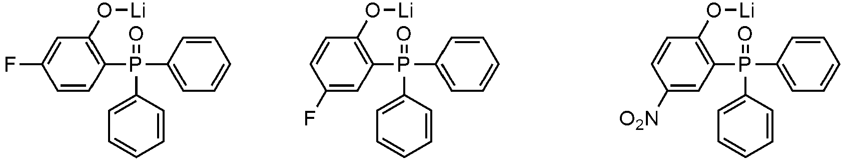

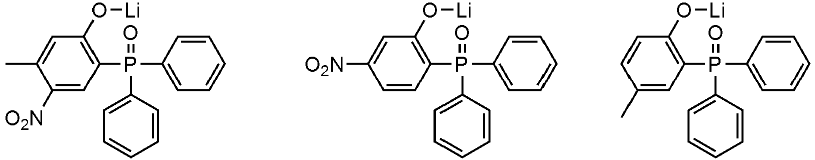

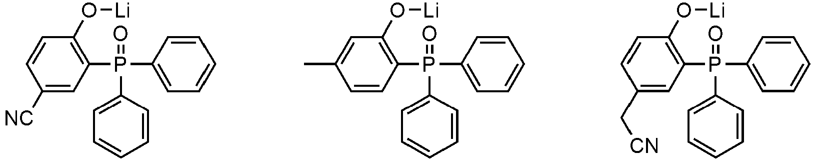

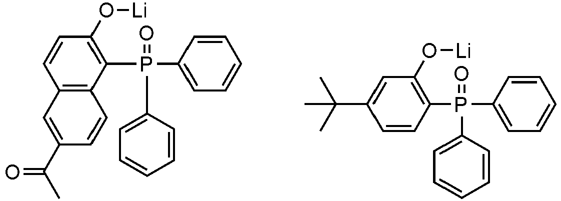

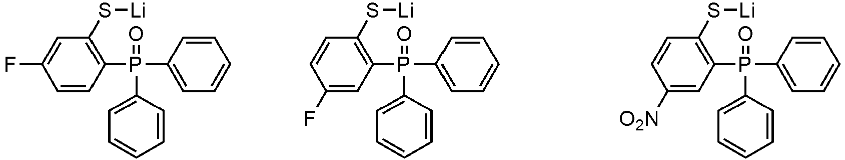

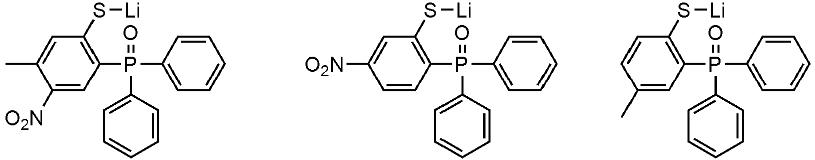

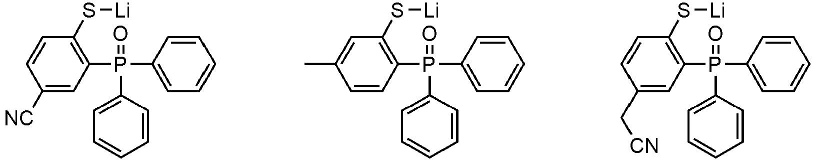

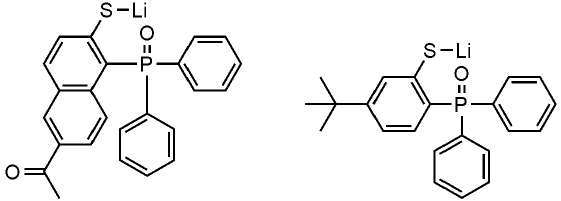

5. An organic light emitting device comprising: a first electrode; a second electrode that is provided opposite to the first electrode; and one or more organic material layers that are provided between the first electrode and the second electrode, wherein one or more layers of the organic material layers comprises the compound of any one of claims 1 to 4.

6. The organic light emitting device according to claim 5, wherein:
the organic material layer comprising the compound is an electron transport layer or an electron injection layer.

## Patentansprüche

1. Verbindung, dargestellt durch eine der folgenden chemischen Formeln 1-1 bis 1-4: 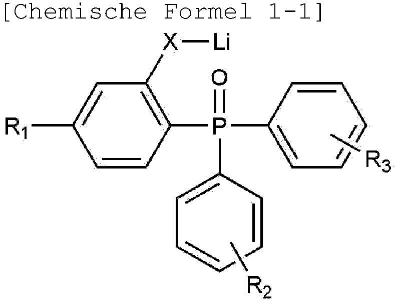 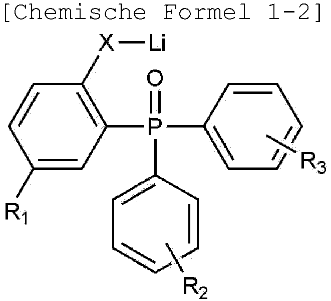 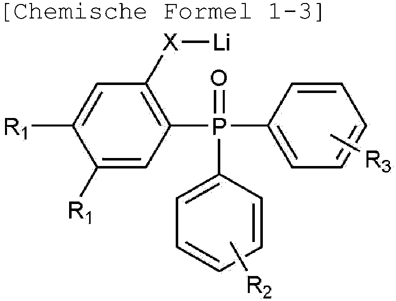 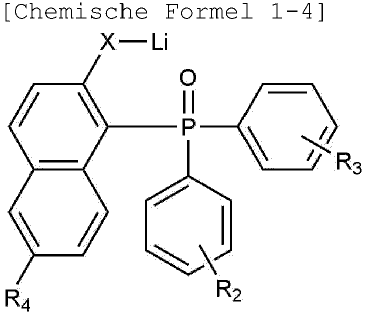
worin in den chemischen Formeln 1-1 bis 1-4
jedes R₁ unabhängig Halogen, Nitro, Cyano, ein C₁₋₆₀-Alkyl oder ein mit Cyano substituiertes C₁₋₆₀-Alkyl ist,
R₂ Wasserstoff oder Deuterium ist,
R₃ Wasserstoff, Deuterium oder Halogen ist und
R₄ -CO-(C₁₋₆₀-Alkyl) ist.

2. Verbindung gemäß Anspruch 1, worin
jedes R₁ unabhängig Methyl, Ethyl, Propyl, Isopropyl, Butyl, Isobutyl, tert-Butyl, Cyanomethyl, Cyanoethyl, Cyanopropyl, Cyanoisopropyl, Cyanobutyl, Cyanoisobutyl, Cyano-tert-Butyl, Fluor, Chlor, Nitro oder Cyano ist.

3. Verbindung gemäß Anspruch 1, worin
R₃ Wasserstoff oder Deuterium ist.

4. Verbindung gemäß Anspruch 1, wobei
die durch eine der folgenden chemischen Formeln 1-1 bis 1-4 dargestellte Verbindung eine ist, die ausgewählt ist aus der Gruppe bestehend aus:

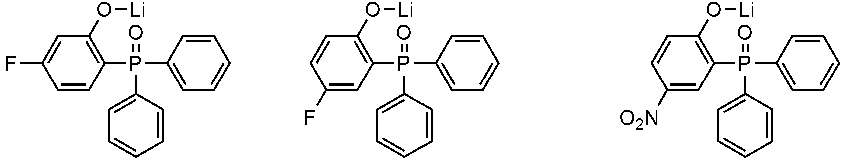

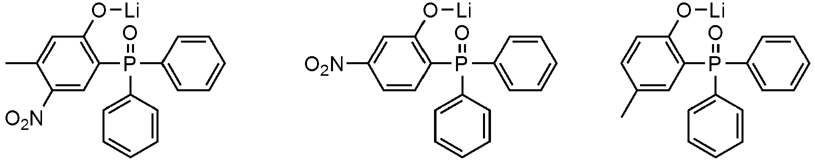

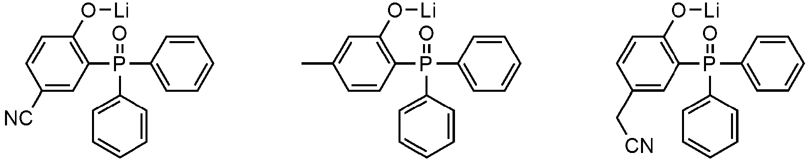

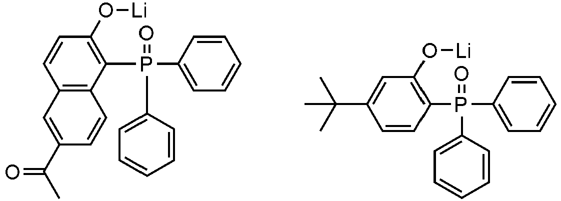

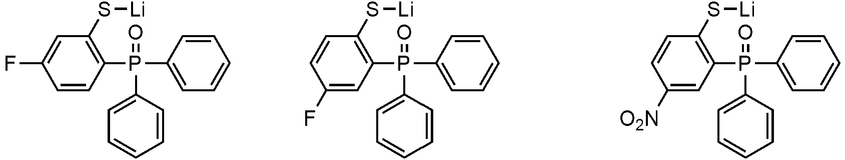

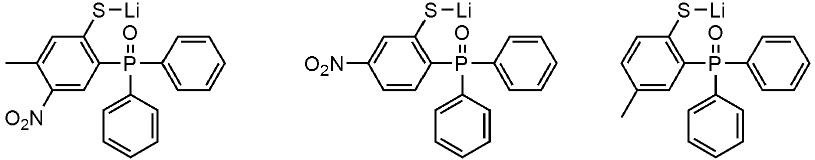

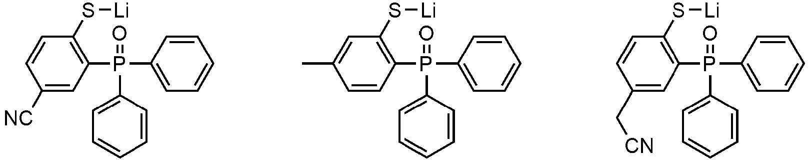

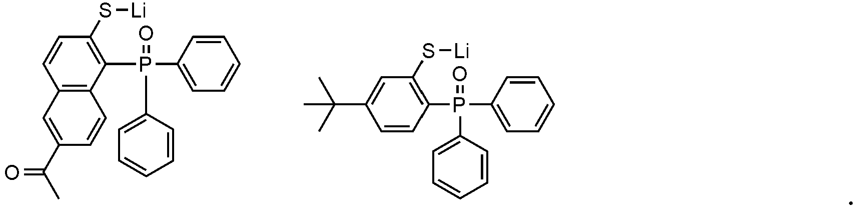

5. Organische lichtemittierende Vorrichtung, umfassend:
eine erste Elektrode; eine zweite Elektrode, die der ersten Elektrode gegenüberliegend angeordnet ist; und eine oder mehrere Schichten aus organischem Material, die zwischen der ersten Elektrode und der zweiten Elektrode angeordnet sind, wobei eine oder mehrere der Schichten aus organischem Material die Verbindung gemäß mindestens einem der Ansprüche 1 bis 4 umfassen.

6. Organische lichtemittierende Vorrichtung gemäß Anspruch 5, wobei:
die Schicht aus organischem Material, die die Verbindung umfasst, eine Elektronentransportschicht oder eine Elektroneninjektionsschicht ist.

## Revendications

1. Composé représenté par l'une quelconque des formules chimiques 1-1 à 1-4 qui suivent : 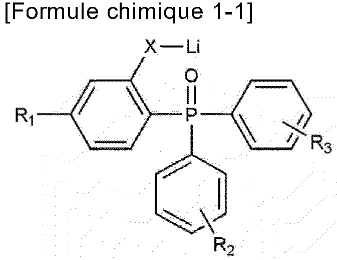 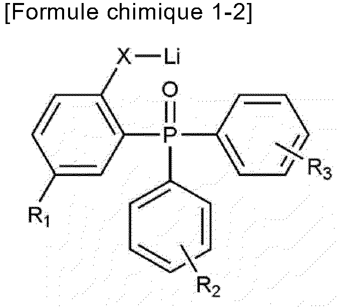 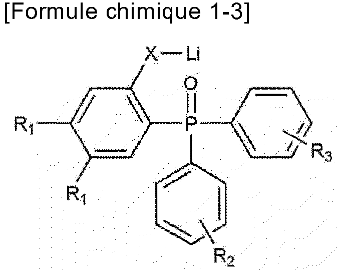 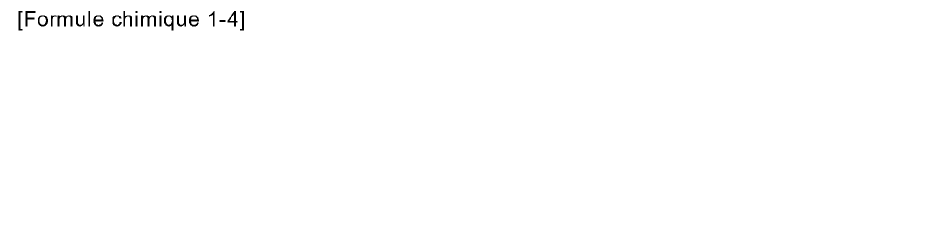 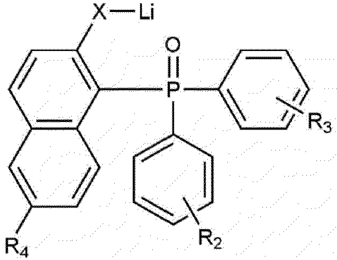
dans les formules chimiques 1-1 à 1-4,
X est O ou S,
chaque R₁ est indépendamment halogène, nitro, cyano, un alkyle en C₁₋₆₀, ou un alkyle en C₁₋₆₀ substitué par cyano,
R₂ est hydrogène ou deutérium,
R₃ est hydrogène, deutérium ou halogène, et
R₄ est -CO-(alkyle en C₁₋₆₀).

2. Composé selon la revendication 1, dans lequel :
chaque R₁ est indépendamment méthyle, éthyle, propyle, isopropyle, butyle, isobutyle, tert-butyle, cyanométhyle, cyanoéthyle, cyanopropyle, cyanoisopropyle, cyanobutyle, cyanoisobutyle, cyano tert-butyle, fluoro, chloro, nitro, ou cyano.

3. Composé selon la revendication 1, dans lequel :
R₃ est de l'hydrogène ou du deutérium.

4. Composé selon la revendication 1, dans lequel :
le composé représenté par l'une quelconque des formules chimiques 1-1 à 1-4 qui suivent est l'un quelconque, sélectionné, faisant partie du groupe constitué par :

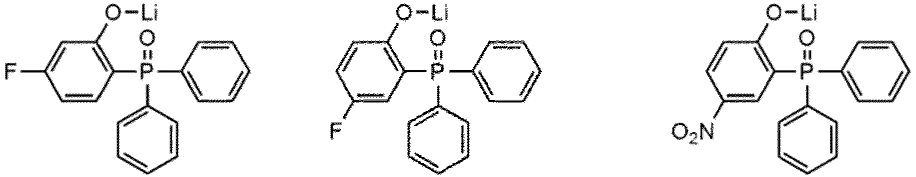

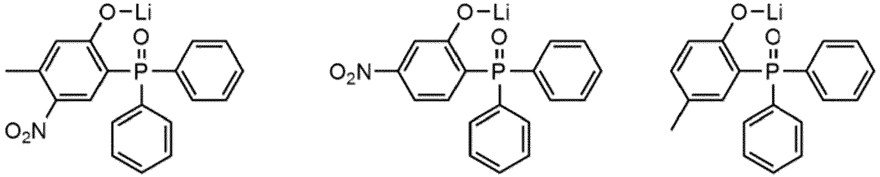

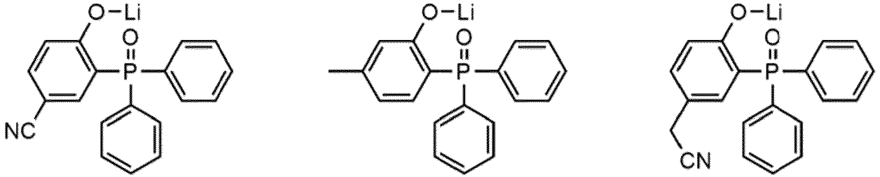

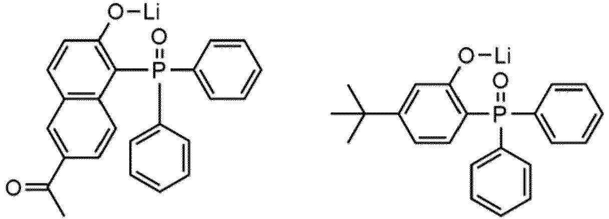

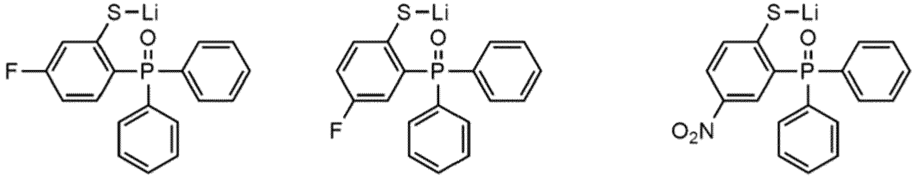

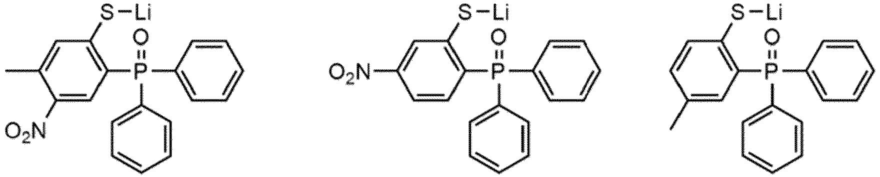

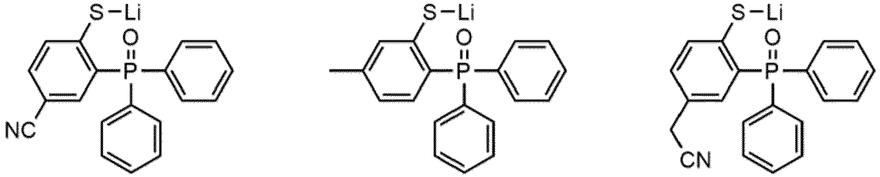

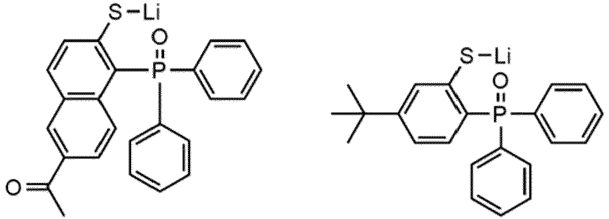

5. Un dispositif émetteur de lumière organique, comprenant : une première électrode ; une deuxième électrode qui est disposée à l'opposé de la première électrode ; et une ou plusieurs couches de matériau organique qui sont disposées entre la première électrode et la deuxième électrode, dans lequel une ou plusieurs couches des couches de matériau organique comprennent le composé selon l'une quelconque des revendications 1 à 4.

6. Dispositif électroluminescent organique selon la revendication 5, dans lequel :
la couche de matériau organique comprenant le composé est une couche de transport d'électrons ou une couche d'injection d'électrons.
